# EUROPEAN PATENT APPLICATION

(11) **EP 2 802 015 A2**
(43) Date of publication of application: **12.11.2014**
(21) Application number: 14001635.3
(22) Date of filing: 08.05.2014
(51) Int. Cl.: H01L 31/042

(54) **Solar cell module and edge tape usable with the same**

(30) Priority: 08.05.2013 KR 20130052074
(71) Applicant: LG Electronics, Inc., Seoul 150-721 (KR)
(72) Inventor: Hong, Seeun, 137-724 Seoul (KR); Han, Ikhyeon, 137-724 Seoul (KR); Kim, Byongsu, 137-724 Seoul (KR); Lee, Youngsik, 137-724 Seoul (KR)
(74) Representative: Frenkel, Matthias Alexander

(57) **Abstract**

Discussed is a solar cell module including a solar cell panel, and a tape shaped sealing member surrounding an edge of the solar cell panel. The sealing member contains at least one of silicone and polyolefin.

## Description

### CROSS-REFERENCE TO RELATED APPLICATION

This application claims the priority benefit of Korean Patent Application No. 10-2013-0052074, filed on May 8, 2013 in the Korean Intellectual Property Office, the disclosure of which is incorporated herein by reference.

### BACKGROUND OF THE INVENTION

### 1. Field of the invention

Embodiments of the invention relate to a solar cell module and an edge tape usable with the same, and more particularly to an edge tape located between a solar cell module and a frame and a solar cell module having the same.

### 2. Description of the Related Art

Recently, due to depletion of existing energy resources, such as oil and coal, interest in alternative sources of energy to replace the existing energy resources is increasing. Most of all, solar cells are popular next generation cells to convert sunlight into electrical energy.

Such solar cells are fabricated into a solar cell module as a plurality of solar cells is interconnected in series or in parallel using a ribbon and then is subjected to packaging for protection thereof. The solar cell module is used to generate electricity for a long term under various environments, and thus requires greater long-term reliability. In general, since sealing performance of the solar cell module is easily deteriorated under high-temperature and high-humidity environments, the solar cell module may easily exhibit deterioration of output power.

### SUMMARY OF THE INVENTION

Therefore, the embodiments of the invention have been made in view of the above problems, and it is an object of the embodiments of the invention to provide a solar cell module, which may prevent deterioration of output power, thus achieving enhanced long-term reliability.

In accordance with one embodiment of the invention, the above and other objects can be accomplished by the provision of a solar cell module including a solar cell panel, a frame surrounding an outer rim portion of the solar cell panel, and a tape shaped sealing member located between the solar cell panel and the frame, wherein the sealing member contains at least one of silicone and polyolefin.

In accordance with another embodiment of the invention, there is provided an edge tape for a solar cell module, the edge tape being shaped to surround the edge of a solar cell panel, wherein the edge tape contains at least one of silicone and polyolefin.

### BRIEF DESCRIPTION OF THE DRAWINGS

The above and other objects, features and other advantages of the embodiments of the invention will be more clearly understood from the following detailed description taken in conjunction with the accompanying drawings, in which:
FIG. 1 is an exploded perspective view showing a solar cell module in accordance with an embodiment of the invention;
FIG. 2 is a sectional view taken along line II-II of FIG. 1;
FIG. 3 is an exploded perspective view showing a solar cell panel included in the solar cell module in accordance with the embodiment of the invention;
FIG. 4 is a view showing an edge tape for the solar cell module in accordance with the embodiment of the invention;
FIG. 5 is a sectional view taken along line V-V of FIG. 4;
FIGS. 6A to 6E are views showing a method for fabricating the solar cell module in accordance with the embodiment of the invention;
FIG. 7 is a sectional view showing an edge tape in accordance with one alternative embodiment of the invention;
FIG. 8 is a sectional view showing an edge tape in accordance with another alternative embodiment of the invention;
FIG. 9 is a sectional view showing an edge tape in accordance with still another alternative embodiment of the invention;
FIG. 10 is a sectional view showing an edge tape in accordance with a further alternative embodiment of the invention;
FIG. 11 is an image of an edge tape fabricated in accordance with an experimental example of an embodiment of the invention;
FIG. 12 shows images showing a solar cell module fabricated in accordance with the experimental example of the embodiment of the invention and quality judgment results thereof; and
FIG. 13 shows images showing a solar cell module fabricated in accordance with a comparative example of the embodiment of the invention and quality judgment results thereof.

### DETAILED DESCRIPTION OF THE EMBODIMENTS

Reference will now be made in detail to the embodiments of the invention, examples of which are illustrated in the accompanying drawings. However, it will be understood that the invention should not be limited to the embodiments and may be modified in various ways.

In the drawings, to clearly and briefly explain the embodiments of the invention, illustration of elements having no connection with the description is omitted, and the same or similar elements are designated by the same reference numerals throughout the specification. In addition, in the drawings, for more clear explanation, the dimensions of elements, such as thickness, width, and the like, are exaggerated or reduced, and thus the thickness, width, and the like of the embodiments of the invention are not limited to the illustration of the drawings.

In the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this refers to there being no intervening elements therebetween.

Hereinafter, a solar cell module and an edge tape usable with the solar cell module in accordance with an embodiment of the invention will be described in detail.

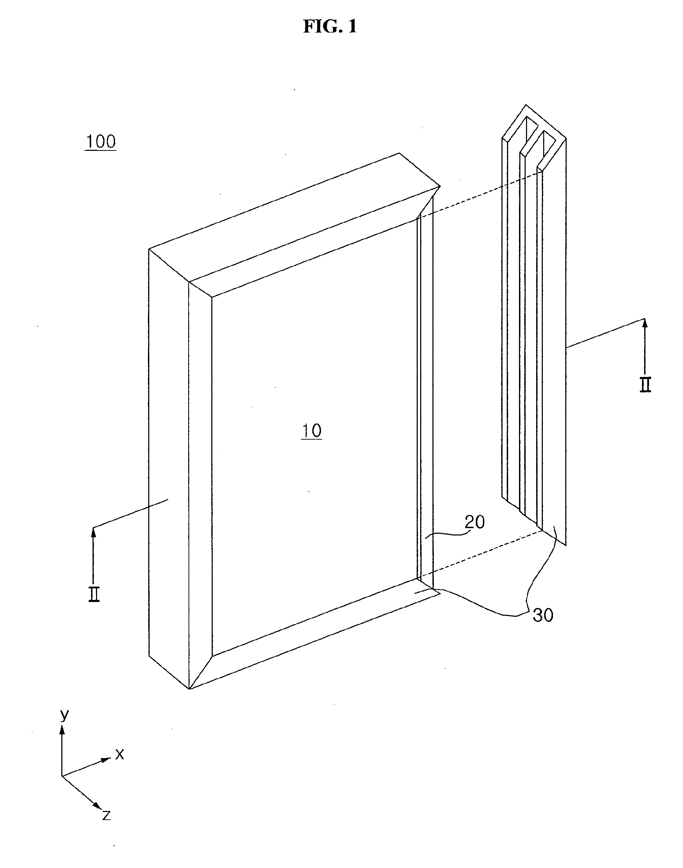

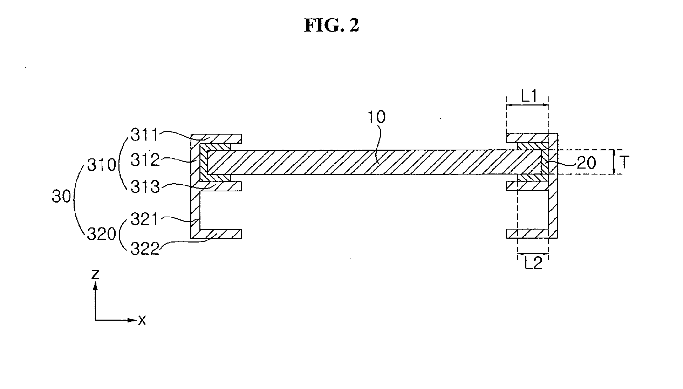

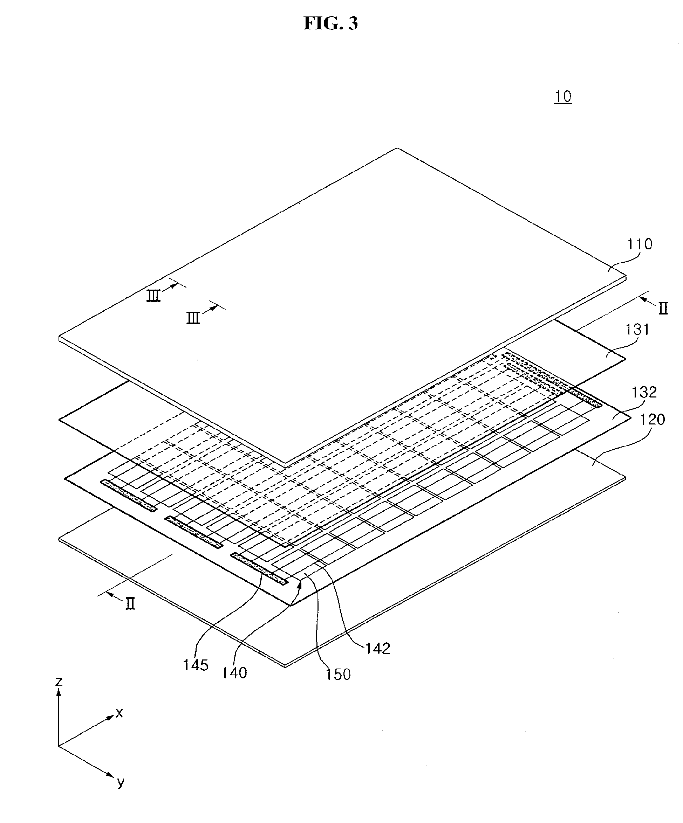

FIG. 1 is an exploded perspective view showing a solar cell module in accordance with an embodiment of the invention, and FIG. 2 is a sectional view taken along line II-II of FIG. 1. In addition, FIG. 3 is an exploded perspective view showing a solar cell panel included in the solar cell module in accordance with the embodiment of the invention.

Referring to FIGS. 1 to 3, the solar cell module, designated by reference numeral 100, in accordance with the embodiment of the invention includes a solar cell panel 10 including at least one solar cell, and a frame 30 surrounding an outer rim portion of the solar cell panel 10. In this instance, an edge tape (or a sealing member) 20 is located between the solar cell panel 10 and the frame 30. This will be described below in more detail.

The solar cell panel 10 may include a solar cell 150, a front substrate 110 disposed on a front surface of the solar cell 150, and a back sheet 120 disposed on a back surface of the solar cell 150. In addition, the solar cell module 100 may include a first sealing material 131 between the solar cell 150 and the front substrate 110, and a second sealing material 132 between the solar cell 150 and the back sheet 120.

In one example, in the embodiment of the invention, the solar cell 150 may be a silicon solar cell fabricated by forming a p-type and/or n-type dopant layer on a semiconductor substrate formed of silicon. However, the embodiment of the invention is not limited thereto. Thus, the solar cell 150 may be any one of various shapes of solar cells, such as a compound semiconductor solar cell, a tandem solar cell, a dye sensitized solar cell, a thin film solar cell, or the like.

The embodiment of the invention illustrates that a plurality of solar cells 150, each taking the form of a silicon solar cell, is interconnected in series, in parallel, or in combinations thereof using a ribbon 142 to construct a solar cell string 140, and in turn a plurality of solar cell strings 140 is interconnected using the bus ribbon 142. However, the embodiment of the invention is not limited thereto, and naturally a connection configuration, connection method, and the like of the solar cells 150 may be altered according to a configuration, type, and the like of the solar cells 150. In addition, as occasion demands, providing only one solar cell 150 is possible.

The first sealing material 131 may be located on one surface of the solar cell 150 and the second sealing material 132 may be located on the other surface of the solar cell 150. The first sealing material 131 and the second sealing material 132 may be adhesively attached via lamination. The first and second sealing materials 131 and 132 serve to block moisture or oxygen that may have a negative effect on the solar cell 150 and to achieve chemical bonding of constituent elements of the solar cell 150. The first sealing material 131 and the second sealing material 132 may be ethylene vinyl acetate (EVA) copolymer resin, polyvinyl butyral, silicone resin, ester-based resin, olefin-based resin, or the like.

However, the embodiment of the invention is not limited thereto. Thus, the first and second sealing materials 131 and 132 may be one or more various other materials, and may be disposed on the solar cell 150 via various other methods rather than lamination.

The front substrate 110 is disposed on the first sealing material 131 to transmit sunlight. Preferably, the front substrate 110 is tempered glass to protect the solar cell 150 from external shock, and the like. Additionally, low-iron tempered glass containing a low amount of iron may be used to prevent reflection of sunlight and to increase transmittance of sunlight. Alternatively, glass with no added sodium may be used to prevent deterioration of output power.

The back sheet 120 is a layer to protect the solar cell 150 at the back surface of the solar cell 150 and has waterproof, insulation, and anti-ultraviolet functions. The back sheet 120 may be Tedlar/PET/Tedlar (TPT) without being limited thereto. Additionally, the back sheet 120 may be formed of a high reflectance material to enable reflection and reuse of sunlight introduced from the front substrate 110. However, the embodiment of the invention is not limited thereto, and the back sheet 120 may be formed of a transparent material to allow transmission of sunlight, which enables realization of a double-sided solar cell module 100.

To stably fix the solar cell module 10 having a multi-layered form described above and to protect the solar cell 150, the frame 30 may be located to surround the outer rim portion of the solar cell panel 10. Although the drawing shows the frame 30 as surrounding the entire outer rim of the solar cell panel 10, the embodiment of the invention is not limited thereto. Thus, various alterations, such as, for example, an alteration in which the frame 30 surrounds only a portion of the solar cell panel 10, are possible.

In the embodiment of the invention, the frame 30 may include a first frame part 310 into which at least a portion of the solar cell panel 10 is inserted, and a second frame part 320 extending outward from the first frame part 310.

More specifically, the first frame part 310 may be comprised of a first portion 311 located at a front surface of the solar cell panel 10, a second portion 312 located at a lateral surface of the solar cell panel 10, and a third portion 313 located at a back surface of the solar cell panel 10. These portions 311, 312, and 313 of the first frame part 310 may be connected to one another to define a space into which the outer rim portion of the solar cell panel 10 is inserted. In one example, the first frame part 310 may have a "U"-shaped or " 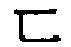 "-shaped form. The second frame part 320 may be comprised of an orthogonal portion 321 extending rearward from the first frame part 310 so as to be orthogonal to the solar cell panel 10, and a parallel portion 322 bent from the orthogonal portion 321 to extend parallel to the back surface of the solar cell panel 10 with a constant distance therebetween. In one example, the second frame part 320 may have an "L"-shaped form. However, the shape of the frame 30 may be altered in various ways, and the embodiment of the invention is not limited thereto.

The second frame part 320 (more particularly, the parallel portion 322) may include a region where a fastening member, which will be fastened to, for example, an external support member, is fixed. By positioning the fastening member for fastening with the support member at the second frame part 320, easy coupling between the solar cell panel 10 and the support member as well as protection of the solar cell panel 10 may be accomplished.

The frame 30 described above may be secured to the solar cell panel 10 in various ways. In one example, the outer rim portion of the solar cell panel 10 may be an elastic portion (for example, an elastic tape), and the solar cell panel 10 may be inserted into the first frame part 310 using the elastic portion thereof. Alternatively, as shown in the drawing by example, the frame 30 may consist of a plurality of lengthwise connectable parts (for example, linear parts) to correspond to each edge of the solar cell panel 10, and the solar cell panel 10 may be secured to the frame 30 as each part is secured to a corresponding edge of the solar cell panel 10. However, the embodiment of the invention is not limited thereto, and naturally various other alterations are possible.

The edge tape 20 is located between the solar cell panel 10 and the frame 30 to surround the edge of the solar cell panel 10. The edge tape 20 may serve to protect the edge of the solar cell panel 10, to prevent invasion of external materials, such as oxygen, moisture, and the like, and to prevent current leakage between the solar cell panel 10 and the frame 30. In the embodiment of the invention, the edge tape 20 may effectively prevent deterioration in the output power of the solar cell module 100. This will be described below in more detail.

By finishing the edge of the solar cell panel 10 with the edge tape 20, easier finishing work may be possible and invasion of external materials and current leakage may be prevented. More specifically, conventionally, a liquid-phase sealing material is applied to the edge of the solar cell panel 10 and cured in air to finish the edge of the solar cell panel 10. This conventional finishing method requires application of the liquid-phase sealing material to each edge of the solar cell panel 10 and also requires standby until the liquid-phase sealing material is cured, thus resulting in difficulty of finishing work. In addition, difficulty in uniformly applying the liquid-phase sealing material may cause defective products. On the other hand, in the embodiment of the invention, the edge of the solar cell panel 10 is finished using the edge tape 20, which may ensure easier finishing work, eliminate curing time, and enable uniform finishing of the edge of the solar cell panel 10.

In this instance, the edge tape 20 may include a silicone or polyolefin layer to prevent deterioration of output power under high-temperature and high-humidity environments (for example, Potential Induced Degradation (PID)). PID refers to deterioration of output power due to a large potential difference between the frame 30 and a negative terminal of the solar cell panel 10. PID may be closely associated with volume resistivity of the sealing member (in the embodiment of the invention, the edge tape 20) between the frame 30 and the solar cell panel 10. Silicone or polyolefin contained in the edge tape 20 of the embodiment of the invention has excellent volume resistivity and may effectively prevent PID. In particular, silicone or polyolefin has higher volume resistivity than other materials (for example, acryl) under high-temperature and high-humidity environments and may effectively prevent PID under high-temperature and high-humidity environments. In addition, silicone or polyolefin has excellent waterproof, sealing, and voltage withstand (withstand voltage) properties, and may be excellent to effectively prevent PID. This will be described below in more detail.

In the embodiment of the invention, sealing

(finishing or encapsulation) between the solar cell panel 10 and the frame 30 is implemented by the edge tape 20. That is, the edge tape 20 is located to surround the edge of the solar cell panel 10 and the frame 30 is located to surround the edge tape 20. In this instance, the edge tape 20 has symmetrical portions on the basis of the solar cell panel 10, one of the symmetrical portions being located at the front surface of the solar cell panel 10 and the other symmetrical portion being located at the back surface of the solar cell panel 10. That is, the portion of the edge tape 20 located at the front surface of the solar cell panel 10 and the portion of the edge tape 20 located at the back surface of the solar cell panel 10 have substantially the same width. In this instance, the expression "substantially the same" includes the meaning of accurately the same as well as sameness that can be recognized as being equal to each other in consideration of process tolerance and the like. With this configuration, it is possible to prevent the edge tape 20 from being separated from the solar cell panel 10.

In this instance, the edge tape 20 is located in an internal region of the frame 30. More specifically, the edge tape 20 is located inside the first and third portions 311 and 313 of the frame 30 disposed respectively on the front surface and the back surface of the solar cell panel 10 so as to overlap the first and third portions 311 and 313 respectively. Thus, the edge tape 20 is located so as not to protrude outward of the first and third portions 311 and 313 of the frame 30. This may provide improved external appearance.

In one example, a first width L1 of the first and second portions 311 and 313 of the frame 30 disposed respectively on the front surface and the back surface of the solar cell panel 10 (more specifically, an inward protruding length from an inner surface of the second portion 312) is greater than a second width L2 of the portions of the edge tape 20 disposed on the front surface and the back surface of the solar cell panel 10. In this instance, a ratio L2/L1 of the second width L2 to the first width L1 may be within a range of 0.5 to 1. When the ratio L2/L1 is below 0.5, the second width L2 of the edge tape 20 is too small to achieve sufficient sealing and the edge tape 20 may be easily separated from the solar cell panel 10. When the ratio L2/L1 exceeds 1, the edge tape 20 protrudes outward of the frame 30, detracting from an external appearance. However, the embodiment of the invention is not limited thereto, and various alterations are possible.

A ratio L2/T of the second width L2 of the edge tape 20 to a thickness T of the solar cell panel 10 may be within a range of 0.3 to 3. When the ratio L2/T is below 0.5, the edge tape 20 may be easily separated from the solar cell panel 10. When the ratio L2/T exceeds 3, the edge tape 20 may protrude outward of the frame 30, detracting from the external appearance. To achieve increased fixing stability and improved external appearance, the ratio L2/T may be within a range of 0.5 to 1.5 (for example, within a range of 0.5 to 1.0). However, the embodiment of the invention is not limited thereto, and various alterations are possible.

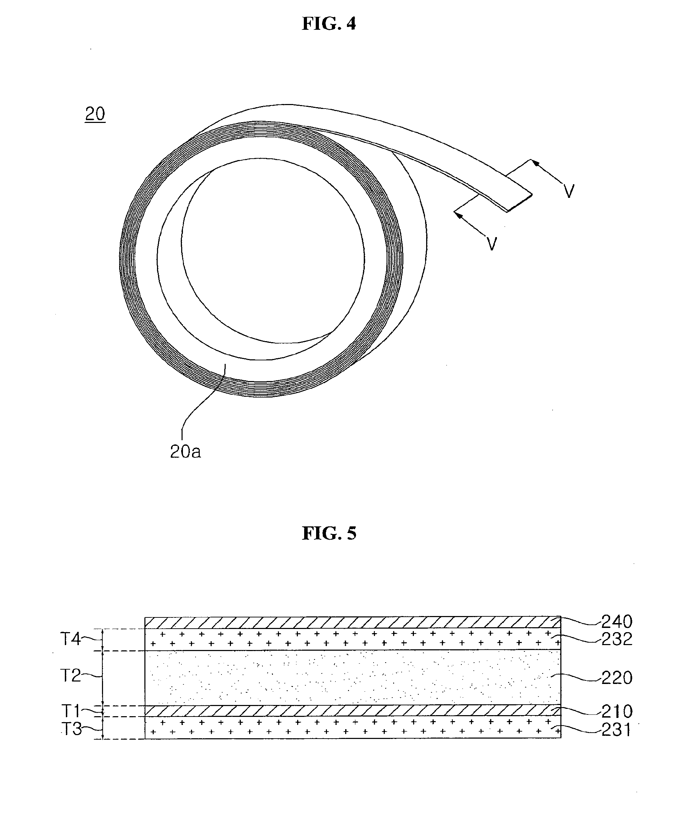

A detailed configuration of the edge tape 20 will be described below in detail with reference to FIGS. 4 and 5. FIG. 4 is a view showing the edge tape for the solar cell module in accordance with the embodiment of the invention, and FIG. 5 is a sectional view taken along line V-V of FIG. 4.

Referring to FIG. 4, the edge tape 20 in accordance with the embodiment of the invention takes the form of a roll wound on a winding core 20a. The edge tape 20 in the form of a roll may be stored in a small volume without a risk of entanglement and may be easily unwound for use. However, the embodiment of the invention is not limited thereto, and the edge tape 20 may have any one of various other shapes.

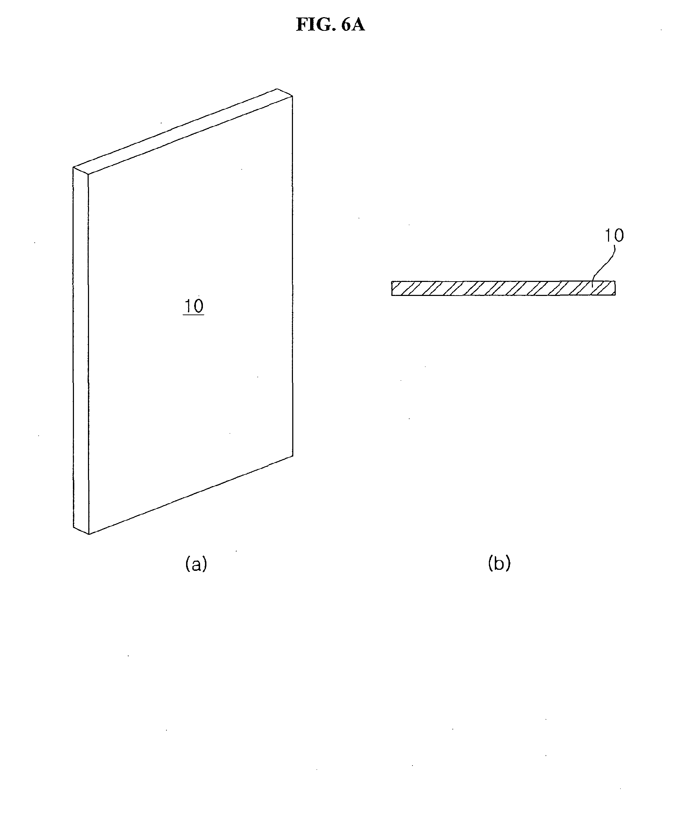

Referring to FIG. 5, the edge tape 20 includes a tape body 210, a cushion member 220 formed at one surface (in the drawing, an upper surface) of the tape body 210, and a first adhesive layer 231 formed at the other surface (in the drawing, a lower surface) of the tape body 210. In addition, the edge tape 20 may further include a second adhesive layer 232 and a release layer 240 formed on the cushion member 220. In this instance, the first adhesive layer 231 is inwardly oriented in a wound state of the edge tape 20, and is exposed outward when the edge tape 20 is unwound for use. The exposed first adhesive layer 231 will be attached to the solar cell panel 10. This will be described below in more detail with reference to FIGS. 6A to 6E.

The tape body 210 is integrally formed with, for example, the cushion member 220 and the first adhesive layer 231, which may ensure easier finishing work of the edge of the solar cell module 100. To this end, the tape body 210 may be formed of one or more of various materials that may ensure easy formation of the cushion member 220 and the first adhesive layer 231 thereon, may exhibit flexibility to allow the tape body 210 to be stored in a roll form and to be deformable when attached to the solar cell panel 10, and may provide hardness suitable to support the cushion member 220 and the first adhesive layer 231. The tape body 210 may be formed of a resin or ceramic. Examples of the resin may include polyethylene terephthalate (PET), polyvinyl chloride (PVC), polyethylene (PE), polypropylene (PP), polyvinylidene difluoride (PVDF), polyvinyl fluoride (PVF), polytetrafluoroethylene (PTFE) (for example, Teflon™ by DuPont). The tape body 210 may be formed of one or more various other materials.

The cushion member 220 serves to substantially prevent PID and to absorb physical shock. To this end, the cushion member 220 absorbs external physical shock, blocks external materials, such as moisture, oxygen, contaminants, and the like, and has high volume resistivity and excellent voltage withstand (withstand voltage) properties.

The cushion member 220 may contain silicone or polyolefin.

Assuming that the cushion member 220 contains silicone, the cushion member 220 may be formed of binary (binuclear) silicone rubber containing a main material and a curing agent. The cushion member 220 formed of a binary silicone rubber is rapidly cured, and thereafter remains in a cured shape thereof. On the other hand, in the instance of pure (mononuclear) silicone, liquid-phase silicone is applied, and thereafter is changed into rubber via reaction with moisture contained in air at room temperature. Therefore, pure silicone has difficulty in uniform application and requires a long curing time.

In this instance, the curing agent may be an additive curing agent. Additive binary silicone rubber using an additive curing agent does not generate byproducts during curing, thus having high stability in terms of dimensions and excellent release ability. Moreover, owing to uniform curing of the interior of a rubber surface, the additive binary silicone rubber achieves excellent deep part curing properties. In addition, the additive binary silicone rubber has excellent electrical stability, and sealing properties, and the like.

Various known materials used to produce silicone rubber may be used as the main material and the curing agent for formation of the cushion member 220. In this instance, each of the main material and the curing agent may be a silicone containing material (for example, polysiloxane), but the main material and the curing agent may have different functional groups, different bonding, or the like. A weight ratio of the main material to the curing agent included in the cushion member 220 may be within a range of 1:0.1 to 1:1. When the weight ratio of the main material to the curing agent is below 1:0.1, curing may be insufficient. When the weight ratio of the main material to the curing agent exceeds 1:1, the amount of the curing agent is greater than the amount of the main material, which may deteriorate productivity of silicone rubber.

The cushion member 220 may further include a catalyst to facilitate curing reaction (for example, a platinum compound). In addition, when it is necessary to provide the cushion member 220 with an adhesive property, the cushion member 220 may further include an adhesive material.

In one example, the cushion member 220 including additive binary silicone rubber may be formed by mixing a main material, a curing agent, and a platinum compound with one another, and then curing the mixture at a given temperature (for example, 50°C to 200°C) for a given time (for example, 5 minutes to 30 minutes). However, the embodiment of the invention is not limited thereto, and naturally a desired cushion member 220 may be formed via various other methods.

Although the above description illustrates the cushion member 220 including silicone rubber, the embodiment of the invention is not limited thereto. In one example, the cushion member 220 may include silicone foam produced by foaming silicone. That is, the cushion member 220 may include various shapes of cured silicone having a given shape and thickness.

In another example, the cushion member 220 containing polyolefin will now be described. Polyolefin is a polymer compound produced via polymerization of olefin (unsaturated open chain hydrocarbon possessing one double bond). Examples of polyolefin may include low density polyethylene (LDPE), linear low density polyethylene (LLDPE), high density polyethylene (HDPE), polypropylene (PP), and ethylene vinyl acetate (EVA).

In one example, the cushion member 220 may include polyolefin foam produced by foaming polyolefin. Since pores of the polyolefin foam are present in a closed cell form, the polyolefin foam has greater adhesion, waterproof, vibration-proof, shock-absorbing, and sealing properties and greater ductility than other resin foams having pores in an open cell form (for example, polyurethane foam and acryl foam). The cushion member 220 described above may be formed by extrusion molding a mixture of polyolefin, a foaming agent, and other additives into a sheet using an extruding machine, crosslinking the sheet via electron beam emission, and thereafter performing high-temperature treatment for foaming.

Although the above description illustrates the cushion member 220 including polyolefin foam, the embodiment of the invention is not limited thereto. For example, the cushion member 220 may include various shapes of cured polyolefin having a given shape and thickness.

The cushion member 220 containing silicone or polyolefin has excellent waterproof, sealing, shock-absorbing properties, and the like, thereby serving to seal the edge of the solar cell panel 10 so as to prevent invasion of external materials and to protect the solar cell panel 10 from external shock.

The first adhesive layer 231, formed on the other surface (the lower surface of the drawing) of the tape body 210, is attached to the solar cell panel 10. The first adhesive layer 231 may be formed of a material that is attachable to the solar cell panel 10. In one example, the first adhesive layer 231 may be formed of a silicone-based material or an acryl-based material. However, the embodiment of the invention is not limited thereto, and naturally the first adhesive layer 231 may be formed of various other materials.

In the embodiment of the invention, the second adhesive layer 232 and the release layer 240, which will be attached to the frame 30, are disposed above the cushion member 220.

Through provision of the second adhesive layer 232, the edge tape 20 and the frame 30 may be more firmly secured to each other. In addition, providing only the edge tape 20 between the solar cell panel 10 and the frame 30 is possible, which may prevent invasion of air and the like. As a result, it is possible to more firmly secure the solar cell panel 10 and the frame 30 to each other and to more effectively prevent invasion of external materials. The second adhesive layer 232 may be formed of a material that is attachable to the solar cell panel 10. In one example, the second adhesive layer 232 may be formed of a silicone-based material or an acryl-based material. However, the embodiment of the invention is not limited thereto, and naturally the second adhesive layer 232 may be formed of various other materials.

The release layer 240, disposed on the second adhesive layer 232, is removed after the edge tape 20 is attached to the solar cell panel 10 using the first adhesive layer 231. Thereby, the second adhesive layer 232 is exposed outward, and in such a state, the second adhesive layer 232 and the frame 30 are attached to each other. The release layer 240 may be formed of one or more various other materials that can be easily peeled from the second adhesive layer 232 as necessary. In one example, the release layer 240 may be a film or sheet that can be easily peeled off.

In the embodiment of the invention, the tape body 210 may have a thickness equal to or less than those of other layers (i.e. the cushion member 220, the first and second adhesive layers 231 and 232, and the release layer 240). The reason why the thickness of the tape body 210 is reduced is to ensure easier attachment to the edge of the solar cell panel 10. In addition, the cushion member 220 may have a thickness equal to or greater than those of other layers (i.e. the tape body 210, the first and second adhesive layers 231 and 232, and the release layer 240). This serves to achieve sufficient voltage withstand (withstand voltage) and waterproof properties, and the like owing to the cushion member 220.

In one example, a thickness of the edge tape 20 may be within a range of 20*µ*m to 2500*µ*m. When the thickness of the edge tape 20 is below 20*µ*m, sealing by the edge tape 20 may be ineffective. When the thickness of the edge tape 20 exceeds 2500*µ*m, sealing using the edge tape 20 may be difficult. When further considering sealing effectiveness and easy work, the thickness of the edge tape 20 may be within a range of 60*µ*m to 1000*µ*m.

A thickness T1 of the tape body 210 may be within a range of 5*µ*m to 500*µ*m. When the thickness T1 of the tape body 210 is below 5*µ*m, physical strength of the edge tape 20 may be insufficient. When the thickness T1 of the tape body 210 exceeds 500*µ*m, the edge tape 20 may have poor flexibility, thus causing difficulty in attachment. When further considering flexibility, the thickness T1 of the tape body 210 may be within a range of 5*µ*m to 50*µ*m.

A thickness T2 of the cushion member 220 may be within a range of 5*µ*m to 1000*µ*m. When the thickness T2 of the cushion member 220 is below 5*µ*m, effectiveness of the cushion member 220 may be low. When the thickness T2 of the cushion member 220 exceeds 1000*µ*m, the edge tape 20 may be unnecessarily thick. Accordingly, to achieve sufficient effectiveness of the cushion member 220, the thickness of the cushion member 220 may be within a range of 50*µ*m to 1000*µ*m.

Thicknesses T3 and T4 of the first and second adhesive layers 231 and 232 may be within a range of 5*µ*m to 500*µ*m respectively. When the thicknesses T3 and T4 of the first and second adhesive layers 231 and 232 are below 5*µ*m, adhesion may be poor. When the thicknesses T3 and T4 of the first and second adhesive layers 231 and 232 exceed 500*µ*m, the edge tape 20 may be unnecessarily thick. Accordingly, in consideration of the thickness of the edge tape 20, the thicknesses T3 and T4 of the first and second adhesive layers 231 and 232 may be within a range of 5*µ*m to 500*µ*m respectively.

The embodiment of the invention is not limited to the above described thicknesses of the edge tape 20, and the tape body 210, the cushion member 220, and the first and second adhesive layers 231 and 232, which constitute the edge tape 20, and naturally these components may have various other thicknesses.

The first adhesive layer 231, the tape body 210, the cushion member 220, the second adhesive layer 232, and the release layer 240 described above may be attached to one another using an adhesive, for example. Alternatively, at least some of the first adhesive layer 231, the tape body 210, the cushion member 220, the second adhesive layer 232, and the release layer 240 may contain an adhesive material so as to be adhered to one another. Alternatively, some layers may be coated over other layers, and thereafter subjected to drying and/or thermal treatments so as to be attached to each other. These layers may be attached and secured to one another via various other methods. In addition, at least some of the first adhesive layer 231, the tape body 210, the cushion member 220, the second adhesive layer 232, and the release layer 240 may be subjected to surface treatments (for example, etching and corona treatment), to achieve enhanced adhesion properties.

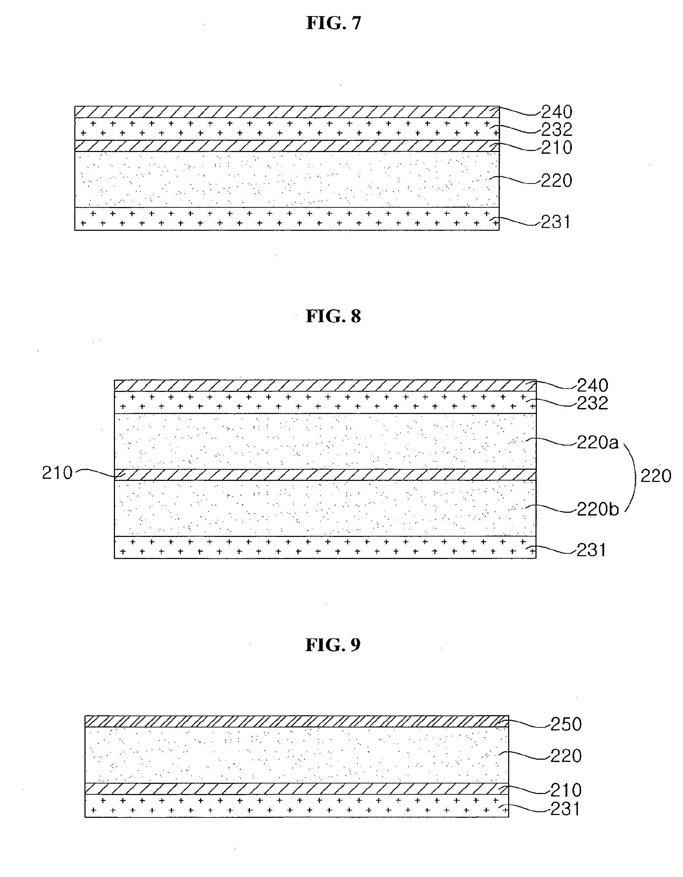

The above described stacking configuration of the edge tape 20 is given by way of example, and the embodiment of the invention is not limited thereto. In one example, the second adhesive layer 232 and the release layer 240 may be omitted. This will be described below in more detail with reference to FIGS. 7 to 10. A process of coupling the solar cell module 100 using the above described edge tape 20 will be described below in more detail with reference to FIGS. 6A to 6E.

FIGS. 6A to 6E are views showing a method for fabricating the solar cell module in accordance with the embodiment of the invention. In FIGS. 6A to 6E, (a) shows a perspective view and (b) shows a sectional view on the basis of FIG. 2.

As shown in FIG. 6A by example, the solar cell panel 10 is prepared.

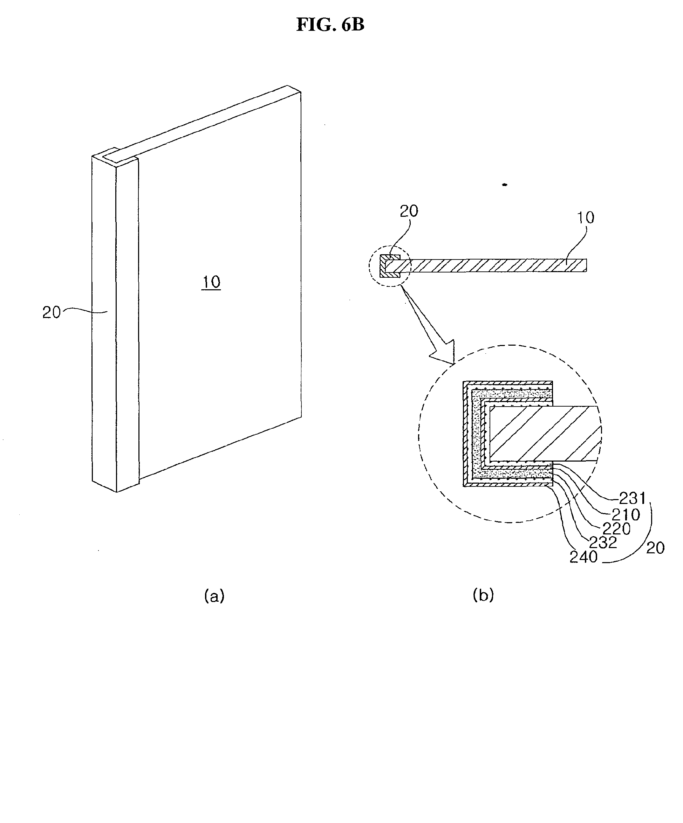

Next, as shown in FIG. 6B by example, the edge tape 20 in the form of a roll is unwound and oriented such that the first adhesive layer 231 faces the solar cell 150. Then, the edge tape 20 is bent to surround the edges of the front surface and the back surface of the solar cell panel 10. In such a state, pressure is applied to the edge tape 20 to secure the edge tape 20 to the edge of the solar cell panel 10.

The embodiment of the invention illustrates that the cushion member 220 is located close to the frame 30 and the tape body 210 is located close to the solar cell panel 10. This arrangement may effectively prevent the high strength frame 30 from applying shock to the solar cell panel 10. However, the embodiment of the invention is not limited thereto, and the cushion member 220 may be located close to the solar cell panel 10 and the tape body 210 may be located close to the frame 30. Various other alterations are possible.

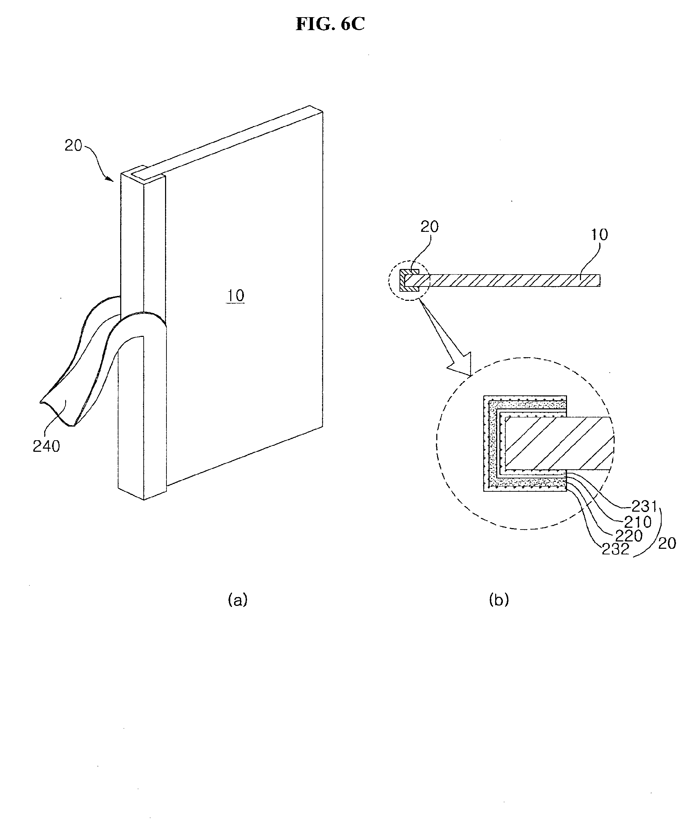

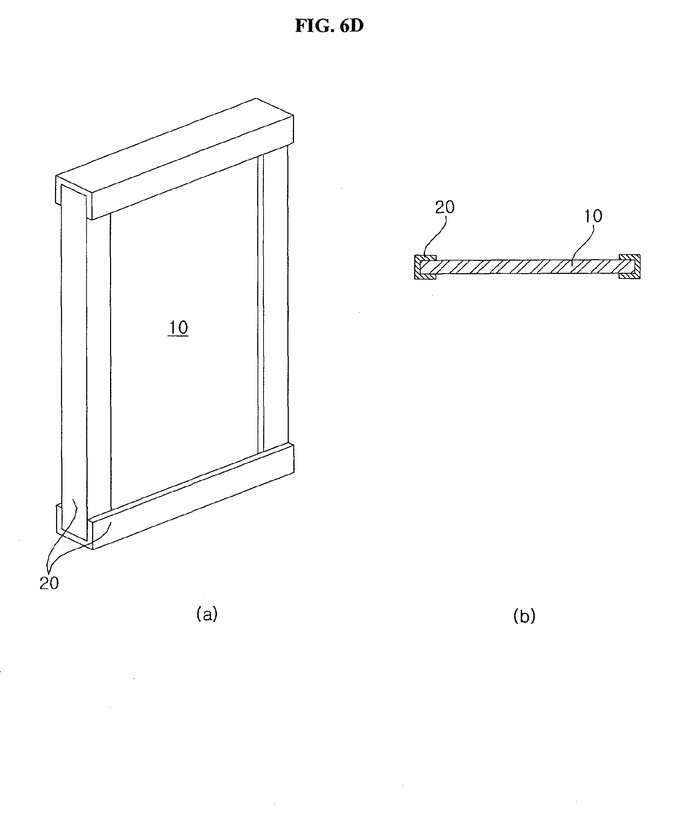

Next, as shown in FIG. 6C by example, the release layer 240, disposed on an outer surface of the edge tape 20, is peeled and removed from the second adhesive layer 232. Thereby, the second adhesive layer 232 is exposed outward after the edge tape 20 is secured to the entire edge of the solar cell panel 10 as shown in FIG. 6D by example.

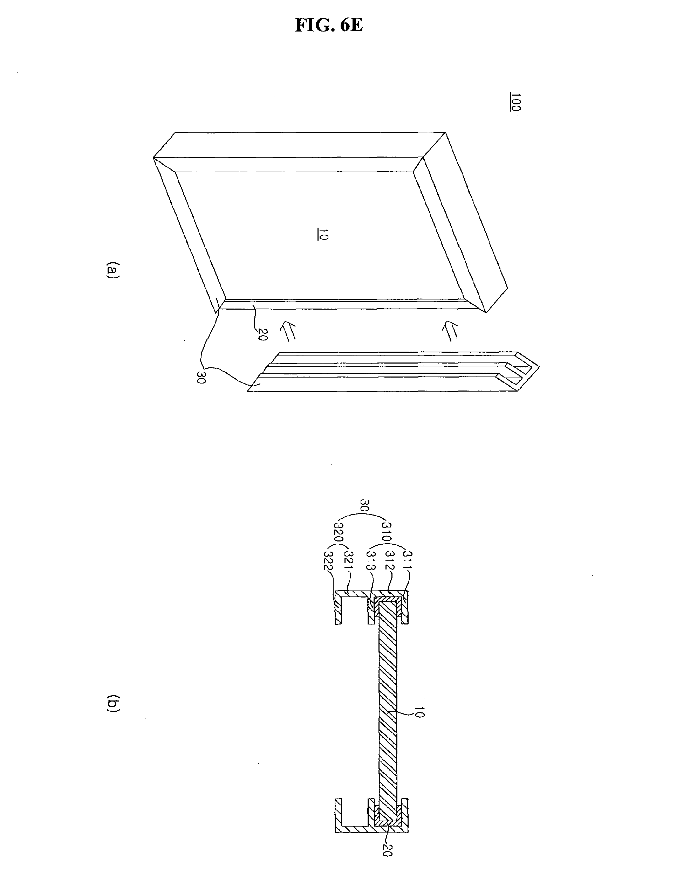

Next, as shown in FIG. 6E by example, pressure is applied to the respective parts of the frame 30 to allow the frame 30 to surround the solar cell panel 10 and the edge tape 20. In this way, the frame 30 is secured by the second adhesive layer 232 of the edge tape 20.

Through use of the edge tape 20 according to the embodiment of the invention as described above, the solar cell module 100 may be fabricated via an easy and simple method. That is, the edge of the solar cell module 100 may be easily sealed with enhanced ease via taping using the edge tape 20. Further, through use of the linear edge tape 20, the edge of the solar cell module 100 may be sealed by a constant thickness. In addition, owing to the cushion member 220 containing silicone or polyolefin, the edge tape 20 may achieve enhanced sealing, waterproof, shock-absorbing, and voltage withstand (withstand voltage) properties, and the like. As a result, it is possible to effectively prevent deterioration in the output power of the solar cell module 100 even when the solar cell module 100 is exposed under high-temperature and high-humidity environments for a long term. This may improve long-term reliability of the solar cell module 100.

In particular, in the embodiment of the invention, the edge tape 20 may take the form of a precured single tape and come into contact with each of the solar cell panel 10 and the frame 30. With this configuration, a securing configuration between the solar cell panel 10 and the frame 30 may be simplified and the edge tape 20 does not require separate curing time later. In addition, expedient storage and transportation of the edge tape 20 and easy finishing work using the edge tape 20 may be accomplished. For example, the flexible edge tape 20 may be fabricated and transported in a roll form as shown in FIG. 4 by example, and then may be unwound for use, which may ensure easier finishing work with respect to the edge of the solar cell panel 100 using the edge tape 20. In this instance, as at least one surface of the edge tape 20 is provided with the adhesive layer 231 and/or the adhesive layer 232, the edge tape 20 remains attached to the solar cell panel 10 and/or the frame 30. More specifically, in an instance in which the edge tape 20 includes the first adhesive layer 231, the entire surface of the edge tape 20 facing the solar cell panel 10 may directly come into contact with the solar cell panel 10 and remain attached thereto. In an instance in which the edge tape 20 includes the second adhesive layer 232, the entire surface of the edge tape 20 facing the frame 30 may directly come into contact with the frame 30 and remain attached thereto. In this way, the edge tape 20 may achieve more firm securing between the solar cell panel 10 and the frame 30 and exhibit excellent waterproof and sealing properties by filling the entire space between the solar cell panel 10 and the frame 30.

On the other hand, differently from the embodiment of the invention, in an instance in which a sealing member used to finish the solar cell panel contains a material that is not cured or partially cured, the material should be carefully stored to remain in an uncured or partially cured state before finishing work, and, for example, a firing process for curing must be additionally implemented after finishing work. This results in deterioration in terms of storage, transportation, and processing of the material. In another example, in an instance in which a cured material is used along with an uncured or partially cured material, these materials have a complicated configuration and storage and transportation thereof are difficult. In particular, in an instance in which a cured material defines a mold having a fixed shape, the material should remain in the shape thereof during storage and transportation thereof, and therefore suffers from difficulty in storage and transportation as well as increased storage and transportation costs due to a large volume thereof. In addition, attaching the cured material to the entire solar cell panel and/or the entire frame is difficult, causing deterioration of waterproof and sealing properties thereof.

Hereinafter, edge tapes in accordance with various alternative embodiments of the invention will be described in detail with reference to the accompanying drawings. A detailed description related to the same or similar parts to the above described parts will be omitted and only different parts will be described in detail.

FIG. 7 is a sectional view showing an edge tape in accordance with one alternative embodiment of the invention.

Referring to FIG. 7, in the alternative embodiment of the invention, the cushion member 220 and the first adhesive layer 231 are formed on one surface of the tape body 210, and the second adhesive layer 232 and the release layer 240 are formed on the other surface of the tape body 210. That is, in the alternative embodiment of the invention, the cushion member 220 is located on the surface of the tape body 210 close to the frame 30. As such, positions of the tape body 210 and the cushion member 220 may be altered in various ways.

FIG. 8 is a sectional view showing an edge tape in accordance with another alternative embodiment of the invention.

Referring to FIG. 8, in the alternative embodiment of the invention, the cushion member 220 is located on either surface of the tape body 210. That is, a first cushion member 220a is located on one surface of the tape body 210 and a second cushion member 220b is located on the other surface of the tape body 210. In addition, the second adhesive layer 232 and the release layer 240 are located above the first cushion member 220a, and the first adhesive layer 231 is located below the second cushion member 220b.

As a result of locating the first and second cushion members 220a and 220b on both surfaces of the tape body 210, sealing, waterproof, shock-absorbing, and voltage withstand (withstand voltage) properties, and the like by the first and second cushion members 220a and 220b may further be enhanced.

In this instance, the first cushion member 220a and the second cushion member 220b may be formed of the same material, or may be formed of different materials. When the first and second cushion members 220a and 220b are formed of the same material, the edge tape may be fabricated via a simple process, such as, for example, double-sided coating. Alternatively, when the first cushion member 220a is formed of silicone and the second cushion member 220b is formed of polyolefin, the edge tape 20 may exhibit properties of silicone as well as properties of polyolefin. In this instance, the first cushion member 220a formed of silicone may be located close to the solar cell panel 10 and the second cushion member 220a formed of polyolefin may be located close to the frame 30. Alternatively, the first cushion member 220a formed of silicone may be located close to the frame 30 and the second cushion member 220a formed of polyolefin may be located close to the solar cell panel 10. Alternatively, any one of the first and second cushion members 220a and 220b may be formed of silicone or polyolefin, and the other one may contain a material except for silicone and polyolefin (for example, acryl-based resin). Various other alterations are possible.

FIG. 9 is a sectional view showing an edge tape in accordance with still another alternative embodiment of the invention.

Referring to FIG. 9, in the alternative embodiment of the invention, the second adhesive layer 232 and the release layer 240, which will be located close to the frame 30, are not formed. That is, the edge tape includes the tape body 210, the cushion member 220 formed on one surface (the upper surface of the drawing) of the tape body 210, and the first adhesive layer 231 formed on the other surface (the lower surface of the drawing) of the tape body 210. A protection film 250 may be disposed on the cushion member 220. The protection film 250 is not essential and may be omitted. The alternative embodiment of the invention may reduce fabrication costs owing to a simplified configuration.

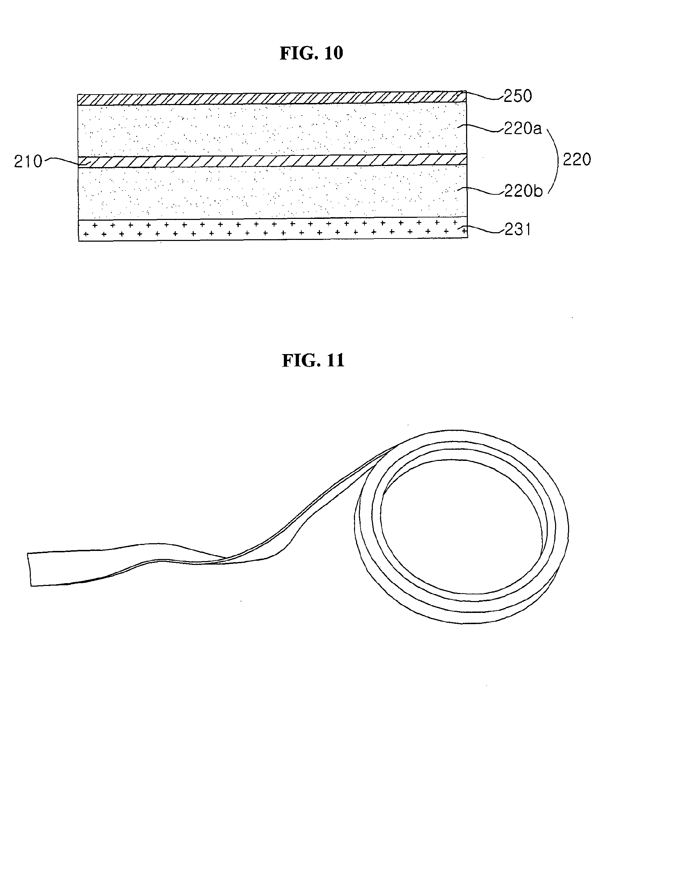

FIG. 10 is a sectional view showing an edge tape in accordance with a further alternative embodiment of the invention.

Referring to FIG. 10, according to the alternative embodiment of the invention, the first and second cushion members 220a and 220b are disposed respectively on both surfaces of the tape body 210, and the second adhesive layer 232 and the release layer 240 are not provided. That is, the edge tape includes the tape body 210, the first cushion member 220a formed on one surface (the upper surface of the drawing) of the tape body 210, and the second cushion member 220b and the first adhesive layer 231 formed on the other surface (the lower surface of the drawing) of the tape body 210. The protection film 250 may be disposed on the first cushion member 220a. The protection film 250 is not essential and may be omitted. The alternative embodiment of the invention may reduce fabrication costs owing to a simplified configuration.

Hereinafter, the embodiment of the invention will be described in more detail with reference to following examples. The following experimental examples are given by way of example, and the embodiment of the invention is not limited thereto.

### Example

An edge tape, in which a cushion member, which is formed of binary silicone rubber and has a thickness of 100*µ*m, and a silicone-based adhesive layer, are disposed on one surface of a base substrate that contains polyethylene terephthalate and has a thickness of 50*µ*m, and a silicone-based adhesive layer is disposed on the other surface of the base substrate, was fabricated. Then, a solar cell module was fabricated by surrounding the edge of a solar cell panel with the fabricated edge tape and assembling a frame thereto.

### Comparative Example

A tape, formed of an acryl-based material, was prepared. Then, a solar cell module was fabricated by surrounding the edge of a solar cell panel with the edge tape and assembling a frame thereto.

FIG. 11 is a photograph of the edge tape fabricated in accordance with the above example. Referring to FIG. 11, it will be appreciated that the edge tape fabricated in accordance with the example has a roll form and thus has ease in storage.

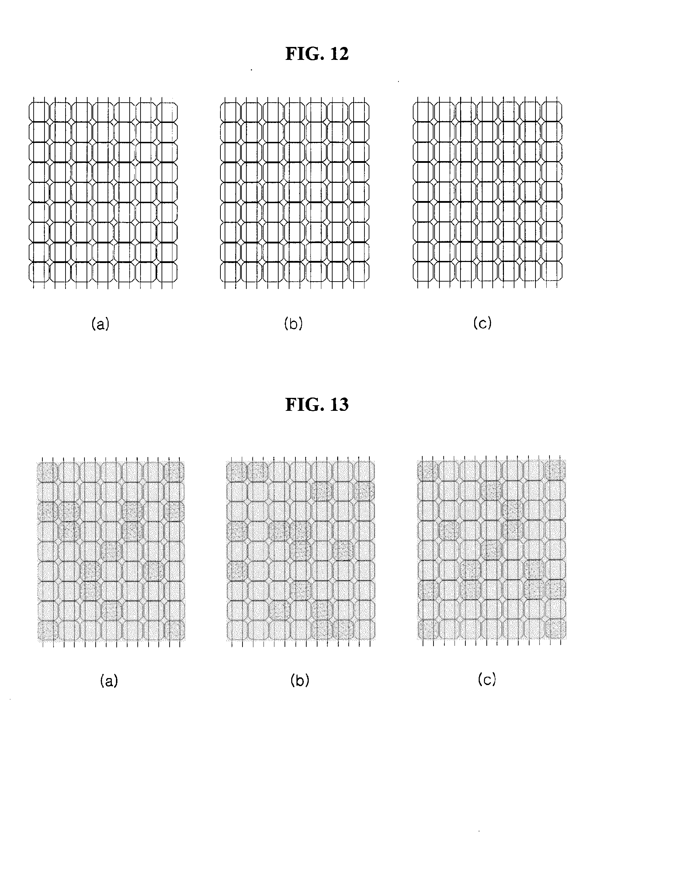

FIGS. 12 and 13 are photographs respectively showing solar cell modules fabricated in accordance with the example and the comparative example. It was judged whether the solar cell modules fabricated in accordance with the example and the comparative example exhibit deterioration of output power of 5% or more and satisfy a current leakage criterion while maintaining the solar cell modules at a temperature in a range of 60°C to 100°C and a humidity of 85% for 4 days (96 hours) under application of 1000 V, and the judged results are illustrated in FIGS. 12 and 13. In addition, the average deterioration value of output power is illustrated in Table 1.

**Table 1**

| | Deterioration of Output Power |
|---|---|
| Example | -0.57% (-1.56W) |
| Comparative Example | -8.460, (-23.86W) |

Referring to FIGS. 12 and 13 and Table 1, it will be appreciated that the solar cell module in accordance with the example almost does not cause deterioration of output power under high-temperature and high-humidity conditions, whereas the solar cell module in accordance with the comparative example causes considerably great deterioration of output power under high-temperature and high-humidity conditions. Accordingly, it will be appreciated that the solar cell module, which is finished using the edge tape in accordance with the example, may be easily fabricated without deterioration of output power owing to excellent voltage withstand (withstand voltage), waterproof, and sealing properties, and the like of the edge tape.

As is apparent from the above description, embodiments of the invention, a solar cell module may be fabricated via an easy and simple method. That is, the edge of the solar cell module may be easily sealed with enhanced ease via taping using an edge tape. Further, through use of the linear edge tape, the edge of the solar cell module 100 may be sealed by a constant thickness. In addition, owing to a cushion member containing silicone or polyolefin, the edge tape may achieve enhanced sealing, waterproof, shock-absorbing, and voltage withstand (withstand voltage) properties, and the like. As a result, it is possible to effectively prevent deterioration in the output power of the solar cell module even when the solar cell module is exposed under high-temperature and high-humidity environments for a long term. This may improve long-term reliability of the solar cell module.

The above described features, configurations, effects, and the like are included in at least one of the embodiments of the invention, and should not be limited to only one embodiment of the invention. In addition, the features,' configurations, effects, and the like as illustrated in each embodiment of the invention may be implemented with regard to other embodiments of the invention as they are combined with one another or modified by those skilled in the art. Thus, content related to these combinations and modifications should be construed as including in the scope and spirit of the invention as disclosed in the accompanying claims.

## Claims

1. A solar cell module comprising:
a solar cell panel;
a frame surrounding an outer rim portion of the solar cell panel; and
a tape shaped sealing member located between the solar cell panel and the frame,
wherein the sealing member contains at least one of silicone and polyolefin.

2. The module according to claim 1, wherein the sealing member is in the form of a single tape and contacts each of the solar cell panel and the frame.

3. The module according to claim 1, wherein the sealing member includes:
a tape body; and
a cushion member formed on the tape body, the cushion member containing the at least one of silicone and polyolefin.

4. The module according to claim 3, wherein the cushion member is formed of at least one of silicon rubber, silicon foam, and polyolefin foam.

5. The module according to claim 3, wherein the cushion member is formed of a binary silicone rubber containing a main material and a curing agent.

6. The module according to claim 5, wherein the curing agent includes an additive curing agent, and the cushion member is formed of a binary additive silicone rubber based on inclusion of the additive curing agent.

7. The module according to one of claims 3 to 6, wherein at least one of the following is fulfilled for the sealing member:
wherein of the cushion member and the tape body, the cushion member is located closer to the frame, and the tape body is located closer to the solar cell panel;
wherein the sealing member further includes an adhesive layer formed on at least one of the tape body and the cushion member; and
wherein the sealing member includes a first adhesive layer located at one side of the tape body and the cushion member, the first adhesive layer being adhesively attached to an edge of the solar cell panel, and a second adhesive layer located at the other side of the tape body and the cushion member, the second adhesive layer being adhesively attached to the frame.

8. The module according to claim 3, wherein the cushion member includes a first cushion member disposed on one surface of the tape body and a second cushion member disposed on the other surface of the tape body.

9. The module according to claim 8, wherein the first cushion member and the second cushion member are formed of the same material, or are formed of different materials.

10. The module according to one of the preceding claims, wherein the frame includes a first frame part, into which the solar cell panel is inserted with the sealing member interposed therebetween,
wherein the first frame part includes a first portion located at one surface of the solar cell panel, a second portion located at a lateral surface of the solar cell panel, and a third portion located at the other surface of the solar cell panel, and
wherein portions of the sealing member disposed respectively on the one surface and the other surface of the solar cell panel are located to wholly overlap the first and third portions of the first frame part.

11. The module according to one of the preceding claims, wherein at least one of the following is fulfilled for the sealing member:
when a width of the first portion or the third portion is a first width and a width of the portion of the sealing member disposed on the one surface or the other surface of the solar cell panel is a second width, a ratio of the second width to the first width is within a range of 0.5 to 1;
wherein the portion of the sealing member disposed on the one surface of the solar cell panel and the portion of the sealing member disposed on the other surface of the solar cell panel are symmetrical to each other on the basis of the solar cell panel; and
wherein a ratio of a width of the portion of the sealing member disposed on a front surface or a back surface of the solar cell panel to a thickness of the solar cell panel is within a range of 0.3 to 3.

12. The module according to one of the preceding claims, wherein a thickness of the sealing member is within a range of 20*µ*m to 2500*µ*m.

13. The module according to one of claims 3 to 12, wherein a thickness of the cushion member is equal to or greater than a thickness of the tape body.

14. An edge tape for a solar cell module, wherein the edge tape is the sealing member according to one of claims 1 to 13.

15. The edge tape according to claim 14, further comprising:
an adhesive layer formed on at least one of the tape body and the cushion member;
a release layer formed on the tape body; or
both,
wherein, when both, the release layer is formed on the adhesive layer.
